# EUROPEAN PATENT SPECIFICATION

(11) **EP 0 578 312 B1**
(45) Date of publication and mention of the grant of the patent: **06.10.1999**
(21) Application number: 93201923.5
(22) Date of filing: 01.07.1993
(51) Int. Cl.: H03M 13/22, H03M 13/00, G11B 20/18, G11B 19/02

(54) **A decoding device for a time-interleaved data stream that is wordwise error protected and has detection for a FIFO jump**
Decodieranordnung für einen zeitlich verschachtelten Datenstrom, mit wortweisem Fehlerschutz und FIFO-Sprung Detektion
Dispositif de décodage d'un flux de données entrelacé temporellement à protection d'erreurs par mots et à détection de sauts de FIFO

(30) Priority: 07.07.1992 EP 92202056
(43) Date of publication of application: 12.01.1994
(73) Proprietor: Koninklijke Philips Electronics N.V., 5621 BA Eindhoven (NL)
(72) Inventor: Cloetens, Henri, c/o Int. Octrooibureau B.V., NL-5656 AA Eindhoven (NL)
(74) Representative: Peters, Rudolf Johannes

(56) References cited:
- EP-A- 0 166 785
- EP-A- 0 260 722
- EP-A- 0 400 810
- US-A- 4 852 099

## Description

### FIELD TO THE INVENTION

The invention relates to a decoding device for decoding a data symbol stream representing a user signal and being organized according to a systematic interleaving mechanism among said symbols, said device having de-interleaving means for de-interleaving said data symbol stream to temporal conformity with said user signal, said device having a contingency detector for detecting a system contingency and thereupon providing pointers indicating selective symbols as suspect, said device having remedial means for under control of said pointers executing a remedial operation in reconstructing said user signal. Without limitation, the user signal may be continuous audio, video, data, or a mixture of these. Various remedial organizations have been proposed for coping with disturbances of the data stream. First, if the analog representation of the user signal has a more or less continuous character, interpolation between contiguous samples may substitute erroneous samples. Second, various digital error protection formats have been standardized, such as for Compact Disc, Digital Compact Cassette, and other consumer entertainment media. The error protection usually operates on three levels: first, detect whether an error is actually present; second, decide on effective error correction measures; third, if correction impossible go for a concealment. Various strategies have been published. The correction may be impossible for a variety of reasons:
a. too many random errors, for example, if the data is broadcast at an insufficient signal strength; in this case, the detection may be on the symbol level, such as demodulation impossible
b. burst error, for example in case a record carrier has mechanical damage; in this case, the detection may also be through specific non-zero syndrome symbols
c. system error, for example in case of a track loss or a track jump; in this case, the signalization may be externally, through a cross-track command or a track loss detector, respectively.

In such audio systems, the error correction operates on the level of digital symbols, the concealment operates on the level of the analog samples. Various other multi-tiered organizations are feasible. This means that the user signal may be accessible at various stages of its development.

All of the above has been recited by way of example only.

### BACKGROUND TO THE INVENTION

The third case, supra, and its handling have been described in US Patent 4,999,828 to Pollen et al. (PHN 12.364) and assigned to the present applicant. The track may be lost intentionally or accidentally and the track loss may be detected according to optical principles. The error causes a decodable word to contain symbols that on itself may be fully correct but constitute parts of respective different source code words. Through the addition of pointers on the system level the device will temporarily refrain from decoding, which may prove impossible and furthermore, may additionally cause loss of decoding time.

The track loss now no longer will cause clicks in the audio signal of a CD-player. However, there are two disadvantages to this organization. First, there is a specific detector outside the data channel. Second, the connection with the actual data symbol stream is loose, which necessitates an enormous number of pointers that drive the device to long-range interpolations and other measures that influence the subjective quality of the user signal, in particular when this is audio.

Moreover, document US-A-4 852 099 discloses a CD-decoder with cross interleaved Reed-Solomon codes comprising the steps of error detecting with a first RS code and setting pointers designating the erroneous words, desinterleaving, and error correcting using a second RS-code, the positions of the erasures being determined by the pointers set by the first RS-code. The problem of discontinuity of frames is solved by an additional decoding pass using the two codes.

### SUMMARY TO THE INVENTION

Now, amongst other things, it is an object of the present invention to mitigate the negative influences of various kinds of disturbances in the stream of data symbols, of which the reference represents only a particular case, and in particular to largely avoid or diminish the negative influences of such disturbance on the structure of the user signal through adequately minimizing the numbers of pointers to an appropriate level. Now, according to one of its aspects, the invention is characterized in that said contingency is a reception discontinuity in said data symbol stream before said de-interleaving, said device being arranged for providing a mapping point of said discontinuity onto said user signal, said detector being arranged for providing said pointers with respect to symbols received before said discontinuity and de-interleaved to after said mapping point and also with respect to symbols received after said discontinuity and de-interleaved to before said mapping point. The ascertaining of the contingency as a reception discontinuity in the data stream keeps as close to the actual damage as possible. Various detector types are feasible. A particular simple one would be to measure the distance between successive synchronization words in the data symbol stream. Any discrepancy over, say, more than two bits would signal some disturbance due to an arbitrary cause. Moreover, the assigning of pointers in this way also is a straightforward procedure.

Especially when the decoding device has a FIFO, FIFO jumps may occur in that the data source has a variable rate outside the range that is normally accomodatable by the FIFO. This situation could be present even if no track loss would occur. It would be clear that FIFO capacity will be kept low for reasons of cost. So there could occur a FIFO overflow as well as a FIFO running empty. These cases are remedied by a FIFO reset, which will be explained in detail hereinafter. The reference first, does not cover such overflow situations, and it is an advantageous aspect of the invention when said contingency is a FIFO-jump within said device, alone, or as a FIFO-overflow cum read-reset combination.

Advantageously, said remedial operation is based on multi-symbol words after said de-interleaving, and symbols thus provided with pointers are minority symbols with respect to symbols that are received with respect to said discontinuity in a temporal direction that is in conformity with that of their de-interleaving destination with respect to said mapping point. Restricting to the in-word minority symbols means that automatically the device stays "at the optimistic side" and the rejecting of total words as unreliable is kept to a minimum. In audio practice, this diminishes the number of clicks to a single one for each FIFO jump. Similar arguments also apply to video, mixed, and other user signals. In the context of present invention, interleaving means that symbols representing the user signal which are contiguously positioned for executing the remedial operation are within the data symbol stream dispersed in a systematic manner to mitigate the possible effects of bursts. The dispersion may be effected either within a finite block, or on the basis of convolution with respect to time.

Advantageously, the remedial operation is effected through the use of a symbol error correcting code. These codes have been found extremely powerful, and are effectively in wide use. However, other measures would be useful as well, such as interpolation, or even recourse the some higher mechanism, such as would be effected in a system with dialogue. Also various mixtures could be feasible.

Advantageously, said device has interface means for interfacing to an inertial record carrier. Especially if the record carrier has an appreciable inertia, it may be subject to shock and acceleration that could influence the data rate appreciably, and the invention diminishes the nuisance caused by the discontinuity.

Advantageously, said record carrier is a disc and said discontinuity is based on a tangential acceleration of said record carrier. Especially rotatable discs are subject to strong accelerations and the invention solves an important problem.

Various advantageous aspects are recited in dependent Claims.

### BRIEF DESCRIPTION OF THE DRAWINGS

The invention will explained in detail hereinafter with respect to a non-limiting preferred embodiment that is shown in and by the accompanying drawings which are in particular:
Figure 1 a block diagram of a decoding device that does not embody the present invention;
Figure 2 a block diagram of an improved decoding device according to the present invention;
Figure 3 shows exemplary time dependent FIFO filling degrees;
Figure 4a shows a FIFO data discontinuity after FIFO overflow;
Figure 4b shows the same after de-interleaving;
Figure 4c shows the same after flagging according to the invention;
Figure 4d shows thereupon the disposition of low-quality data;
Figure 5a shows a user signal example;
Figure 5b shows such user signal exhibiting discontinuities;
Figure 6 shows the effect of a discontinuity in combination with interleaving;
Figure 7 shows such effect on a symbol basis in an elementary example.

### DETAILED DESCRIPTION OF A PREFERRED EMBODIMENT

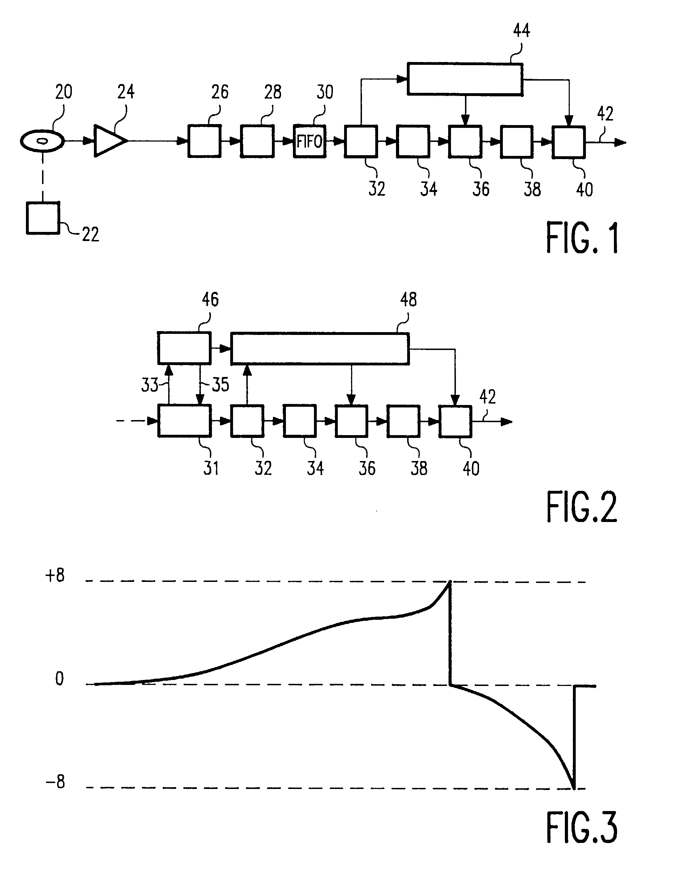

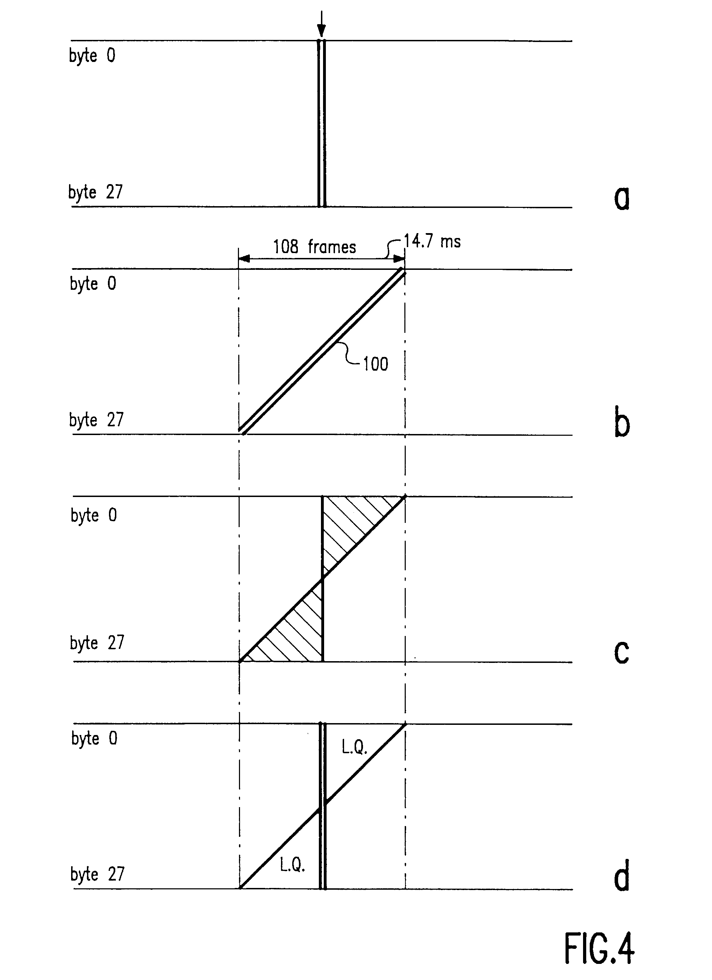

Figure 1 is a block diagram of a decoding device in a Compact Disc environment that does not embody the present invention. Inasmuch as various Compact Disc systems have been published and are in wide use, disclosure is fragmentary only. Compact Disc 20 is shown symbolically and rotated by motor 22 that includes driving feedback. Element 24 symbolizes the pick-up inclusive of various optical, electrical/electronic, and feedback systems. Element 26 symbolizes a phase-locked loop that outputs a stream of clipped channel bits, inclusive of synchronization patterns. Element 28 symbolizes the demodulation that receives a string of 14-bit channel words that are pairwise separated by three separation bits and outputs a string of eight bit code symbols. For simplicity, synchronization headers are ignored. As regards the demodulation, herein demodulation flags are ignored that could signal irregular channel words. Element 30 represents a FIFO that operates on a symbol basis and has independent writing from element 28 as well as reading to element 32. The FIFO has an overflow detector not shown that will reset the FIFO in case of overflow. The resetting may be done by resetting the read pointer. If the rotation of the record is accelerated or decelerated, such as through slight motions while rotating, the filling degree of the FIFO may change somewhat between acceptable limits. In this respect, Figure 3 shows exemplary time dependent FIFO filling degrees. Half-way is filling degree zero that is considered optimum. Maximum filling degree is +8 frames of 32 symbols each. Minimum filling degree is -8 frames, both relative with respect to a half-way filling degree. Total capacity of the FIFO is 16 frames. The read-out is done by the next stage that also sees to the de-interleaving of the symbols. In practice, the actual filling degrees are represented by the positional differences between writing pointer and reading pointer. The Figure shows an initial interval where the filling is halfway. Next, the filling degree increases through increase of the source data rate. When, at a particular instant, the value +8 is reached, there occurs a FIFO reset to filling degree zero (actually halfway full). This resetting renders part of the presently stored data in the FIFO inconsequential because they will not be read. Next, the example shows that the source data rate decreases, so that the FIFO filling degree diminishes (the destination data data rate is constant in good approximation). Upon reaching a value of -8, the FIFO is reset to a notional filling degree of zero (= halfway). This causes the most recent -8 frames to be read a second time, as reading is non-destructive.

In Compact Disc, element 32 symbolizes the decoding of 32 symbol C1 words that are encoded according to a Reed-Solomon code that is systematic on the symbol level. The decoding results are 28 data symbols accompanied by a set of flags that signal various levels of confidence on either a word level or on a symbol level. The flags are forwarded to element 44 that symbolizes a flag handling device. Element 34 symbolizes a de-interleaver that distributes the decoded symbols symbol by symbol over C2 words that are again Reed-Solomon encoded according to a code that is systematic on the symbol level. Element 36 symbolizes the decoding of these 28-symbol words and is co-controlled by appropriate flags received from the flag handling device 44. This decoding may produce new flags for element 44. Element 38 symbolizes a digital to analog converter that should in principle reproduce the user signal as a stream of time discrete and quasi-analog sample amplitudes. Element 40 symbolizes the concealment device that is activated by appropriate flag information received from flag handling device 44. Such samples that are not reproducible by the main channel of elements 24 through 38, are now quasi reproduced through concealment of the output result actually received from converter 38. Various concealment strategies have become conventional, such as holding of previous value, interpolating between previous and following samples according to formulae of various levels of refinement. A further possibility is even complete muting of a sample that is then set at value zero. By itself an embodiment of decoding has been described in US Patent 4,683,572 (PHN 10.931) assigned to the present assignee. In the decoding and de-interleaving extensive use is made of storage space that allows to amend the mutual time relationships between symbols that form part of a single word.

Now, a reset of the FIFO introduces a data discontinuity in time. Each time that the DAC converter outputs a sample from the first side of the discontinuity directly followed by one from the second side of the discontinuity the output will produce a click signal. Herein first and second may means before and after the discontinuity, respectively, or the other way round.

Figure 2 is a block diagram of an improved decoding device according to the present invention. Inasmuch as a large part of the device is not changed with respect to Figure 1, elements 20..28 have not been shown. Furthermore, unchanged elements carry identical reference numerals. Block 46 is a FIFO overflow manager device that detects a overflow or underflow of FIFO 31 as a specific signalization on line 33 and in case of overflow resets FIFO 31 through signalization on line 35. Moreover, certain part of the FIFO contents are subsequently labelled as will be explained hereinafter as unreliable. This labelling may be appended to the contents of FIFO 31. A different solution is to forward this information to flag handling device 48 that now has a somewhat more complicated structure than element 44 in Figure 1. The remaining elements 34..42 are identical to their namesakes in Figure 1.

Now, Figure 4a shows a FIFO data discontinuity after FIFO over-flow. Along the vertical direction the Figure for each row gives the byte number within the 28 byte C2 code word, each code word occupying one column. Along the various rows, the C2 code words are dispersed; for convenience, the parity check symbols of the C1 code words have not been shown separately. In effect, they should cover four additional rows, but they constitute no part of the C2 words. The vertical line indicates the actual occurrence of the discontinuity, that is, contiguous words need not have contiguous word numbers. For simplicity again, any partial word has been suppressed, so that the discontinuity is effectively at the word boundary. In practice, such is effected in that the write pointer always is started upon the reception of the synchronization symbol. Upon the next synchronization symbol, the pointer is stepped for receiving the next frame/word. If however, the word contains less than the intended number of symbols, the writing of the next word in effect overwrites this incomplete word. Now, Figure 4b shows the same after de-interleaving in de-interleaving element 34 as mapped on the input information stream. The discontinuity is now stretched in the horizontal direction over a span of 4∗27 = 108 frames = 14.7 msecs. To the left of inclined line 100 all symbols pertain to the time before the reset discontinuity, to the right of this line to the time after the reset discontinuity if the time goes from left to right in the Figure.

Figure 4c shows the same after flagging according to the invention. Here, on both sides of the inclined discontinuity all symbols which within their column form a minority are flagged as being suspect, which has been indicated by hatching. Figure 4d shows thereupon the disposition of low-quality (L.Q.) data: these either will be corrected by the C2 decoder, or if this proves impossible due to too many symbol flags within a single C2 word, an interpolation sample will be produced. The discontinuity will be restricted in duration, and will also be less audible. If necessary, the remaining discontinuity is concealed by soft muting.

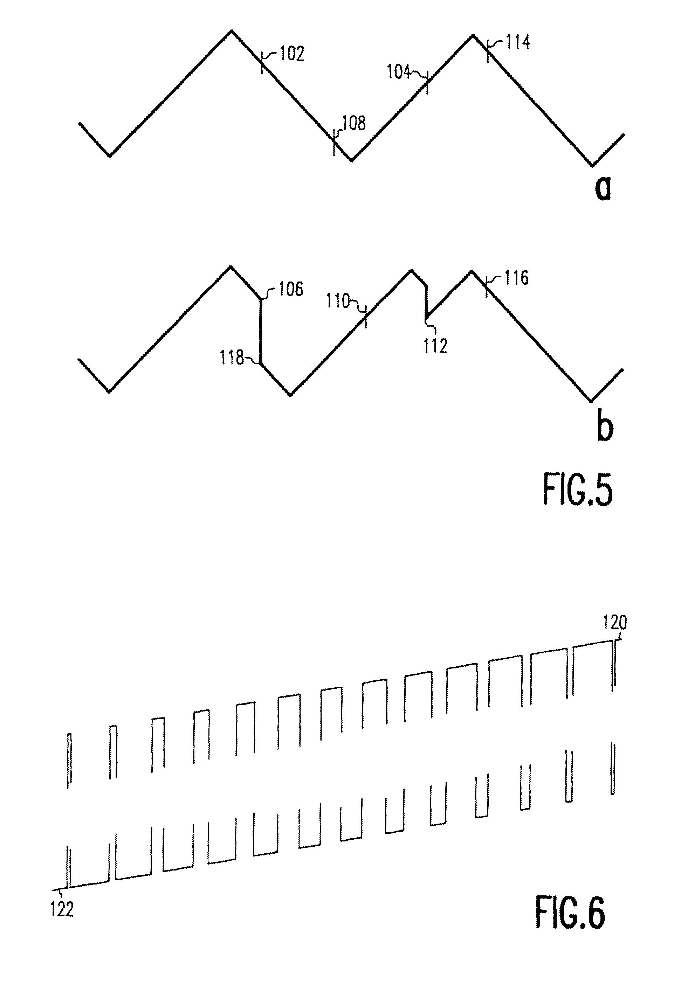

Figure 5a shows an exemplary user signal in the shape of a triangular and periodic waveform. Four specific points have been indicated in the waveform 102, 104, 108, 114. Figure 5b shows the same user signal exhibiting discontinuities. At instant 106, corresponding to 102 in Figure 5a, the signal value instantly steps down to that of 118; this value corresponds to that of 108 in Figure 5a. In consequence, the whole stretch between 102 and 108 is bypassed. Furthermore, between 110 and 112, the signal of Figure 5b corresponds to that of Figure 5a between 104 and 114. Now, however, the latter stretch is repeated between 112 and 116. Other discontinuities may combine the effects of Figures 5a, 5b.

Figure 6 shows the effect of a discontinuity with interleaving. As shown, there is a user signal 122 far before the discontinuity. Also, there is user signal 120 far behind the discontinuity. The discontinuity is of the type 106/118 in Figure 5a, but now the de-interleaving must still be executed. In effect, the user signal now jumps back and forth between two signals that correspond to respective extensions of the signals at 122, 120, respectively. In the beginning the user signal most often corresponds to an extension of signal 122 and rarely to an extension of signal 120. Later on, the two extensions occur more or less equal fractions of time. At the end, the user signal most often corresponds to an extension of signal 120. The transition between these three cases is gradual. As would be clear from Figure 5b, the slopes of signals 120, 122 may be different and also have mutually different signs. Also the signals 120, 122 may in effect have an interception point. For convenience, signals 120, 122 have been drawn as continuous. This however, is not a restriction, inasmuch as, for example, a second de-interleaving operation could have been designed into the system.

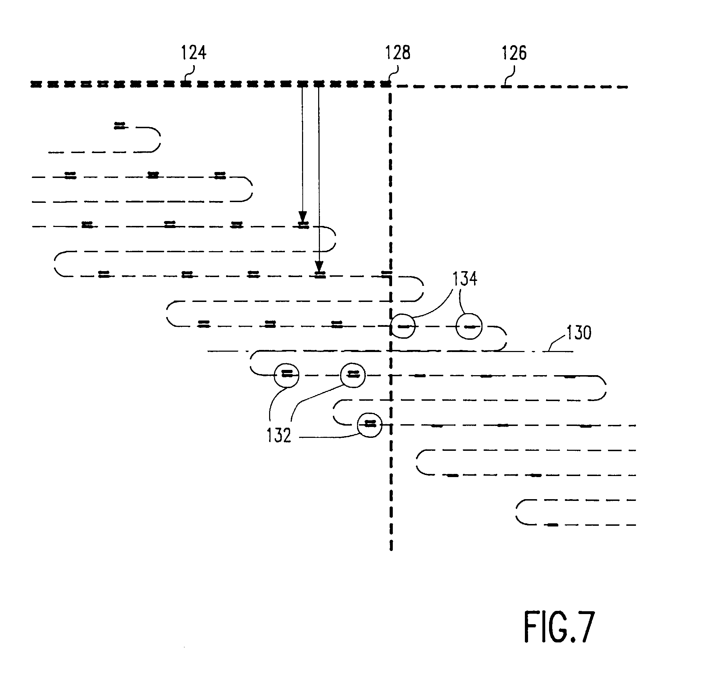

Figure 7 shows the effect on a symbol basis in an elementary example. The interleaved symbol stream is shown at the top as the sequence 124/126: double lines versus single lines each represent one symbol. At 128 a discontinuity occurs. The case that the discontinuity occurs on a lower-than-symbol level is ignored: at most this would lead to a single invalid symbol. This would not influence the subsequent reasoning. Now, the interleaving is shown as having five successive symbols mapping on five successive words that each consist of five symbols. Each word is shown on a single horizontal row. The sequence of the user signal is now according to the dotted line that meanders through the succession of words, from left to right. Now the discontinuity 128 is mapped on an instant in the user signal that is indicated by horizontal wavy line 130. Symbols 132 occur before the discontinuity, but after the mapping point. In consequence, they get a flag or pointer. On the other hand, symbols 134 occur after the discontinuity, but before the mapping point. They also get a flag or pointer. Now, if the words are two-symbol correcting by some error protective code, this means that they could be corrected to "good" words. A final transition now remains on mapping point 130. Without additional measures, this would cause a single click. Through conventional softmuting, this click is masked, however.

The system explained supra may be used in a more complex environment. First, the interleaving pattern could be more complicated, which only would influence the number of symbols the receive a pointer. Second, other symbols could be interspersed that would not adhere to the interleaving pattern, such as headers. These would simply be ignored, with respect to the present invention. Third, the mapping point and/or the discontinuity may be positioned slightly away from their correct values. For example, if discontinuity 128 were replaced one symbol to the left, this would cause a pointer for one additional symbol. Generally this would cause extremely little deterioration to the ultimate user signal. Likewise, replacing it one position to the right would leave one symbol without pointer. A slight misplacement of the mapping point (such as raising or dropping it by one word) likewise would have little influence. The overall effect of such misalignments in practice is small, because near the mapping point most words are incorrectible anyhow because they have always a high percentage of flagged symbols, regardless of the exact location of the mapping point. However, this number of flagged symbols quickly decreases away from the mapping point, and the performance generally remains near optimal. Another solution would be that near the mapping point a small number of words were declared invalid, or that the mapping point were defined as a diffuse region around wavy line 130. An essential element, however, remains that the flagging strategy is based on the properties of the data stream itself.

The embodiments as described represent the preferred embodiments. Various smaller or larger deviations would not depart from the background idea of the invention. Generally, such procedure would leave a minimal number of C2 words uncorrectable while not causing an excessive number of flags have degrade the signal quality.

## Claims

1. A decoding device for decoding a data symbol stream representing a user signal and being organized according to a systematic interleaving mechanism among said symbols, said device having de-interleaving means for de-interleaving said data symbol stream to temporal conformity with said user signal, said device having a contingency detector for detecting a system contingency and thereupon providing pointers indicating selective symbols as suspect, said device having remedial means for under control of said pointers executing a remedial operation in reconstructing said user signal, characterized in that said contingency is a reception discontinuity in said data symbol stream before said de-interleaving, said device being arranged for providing a mapping point of said discontinuity onto said user signal, said detector being arranged for providing said pointers with respect to symbols received before said discontinuity and de-interleaved to after said mapping point and also with respect to symbols received after said discontinuity and de-interleaved to before said mapping point.

2. A decoding device as claimed in Claim 1, wherein said contingency is a FIFO-jump within said device.

3. A decoding device as claimed in Claim 1, wherein said contingency is a FIFO-overflow cum read-reset combination.

4. A decoding device as claimed in Claim 1, 2 or 3, wherein said remedial operation is based on multi-symbol words after said de-interleaving, and symbols thus provided with pointers are minority symbols with respect to symbols that are received with respect to said discontinuity in a temporal direction that is in conformity with that of their de-interleaving destination with respect to said mapping point.

5. A decoding device as claimed in Claim 4, wherein said remedial operation is based on a symbol error correcting code.

6. A decoding device as claimed in any of Claim 1 to 5, and having electromechanical interface means for interfacing to an inertial record carrier.

7. A device as claimed in Claim 5, wherein said record carrier is a disc and said discontinuity is based on a tangential acceleration of said record carrier.

8. A device as claimed in any of Claim 1 to 7, and being executed as a self-contained and portable unit including output means for said user signal.

9. A device as claimed in Claim 5, furthermore comprising a softmuting device that is operational at a final jump on said mapping point in said signal upon reconstitution thereof.

## Patentansprüche

1. Decodieranordnung zum Decodieren eines ein Benutzersignal repräsentierenden Datensymbolstroms, der gemäß einem systematischen Verschachtelungsmechanismus in den genannten Symbolen strukturiert ist, wobei diese Anordnung Entschachtelungsmittel zum Entschachteln des genannten Datensymbolstroms auf zeitliche Übereinstimmung mit dem genannten Benutzersignal aufweist, wobei diese Anordnung einen Kontingenzdetektor zum Detektieren einer Systemkontingenz hat und daraufhin Zeiger verschafft, die selektive Symbole als verdächtig andeuten, wobei die genannte Anordnung Ausbesserungsmittel hat, um unter Steuerung der genannten Zeiger eine Ausbesserungsoperation durch Rekonstruktion des genannten Benutzersignals auszuführen, dadurch gekennzeichnet, dass die genannte Kontingenz eine Empfangsunstetigkeit in dem genannten Datensymbolstrom vor dem genannten Entschachteln ist, wobei die genannte Anordnung ausgebildet ist, um einen Punkt der Abbildung der Unstetigkeit auf das genannte Benutzersignal zu verschaffen, wobei der Detektor ausgebildet ist, um die genannten Zeiger in Bezug auf Symbole zu verschaffen, die vor der genannten Unstetigkeit empfangen und nach dem genannten Abbildungspunkt entschachtelt worden sind und auch in Bezug auf Symbole, die nach der genannten Unstetigkeit empfangen und vor dem genannten Abbildungspunkt entschachtelt worden sind.

2. Decodieranordnung nach Anspruch 1, wobei die genannte Kontingenz ein FIFO-Sprung innerhalb der genannten Anordnung ist.

3. Decodieranordnung nach Anspruch 1, wobei die genannte Kontingenz ein FIFO-Überlauf und eine Lese-Rücksetzkombination gleichzeitig ist.

4. Decodieranordnung nach Anspruch 1, 2 oder 3, wobei die genannte Ausbesserungsoperation auf Mehrsymbolwörtern nach dem genannten Entschachteln beruht und somit mit Zeigern versehene Symbole in Bezug auf Symbole, die in Bezug auf die genannte Unstetigkeit in einer zeitlichen Richtung empfangen worden sind, die mit der ihrem Entschachtelungsziel in Bezug auf den genannten Abbildungspunkt übereinstimmen, Minontätssymbole sind.

5. Decodieranordnung nach Anspruch 4, wobei die genannte Ausbesserungsoperation auf einem Symbolfehlerkorrekturcode beruht.

6. Decodieranordnung nach einem der Ansprüche 1 bis 5 und mit elektromechanischen Schnittstellenmitteln zum Koppeln mit einem trägen Aufzeichnungsträger.

7. Anordnung nach Anspruch 5, wobei der genannte Aufzeichnungsträger eine Platte ist und die Unstetigkeit auf einer Tangentialbeschleunigung dieses Aufzeichnungsträgers beruht.

8. Anordnung nach einem der Ansprüche 1 bis 7 und als unabhängige und tragbare Einheit ausgeführt, die Ausgabemittel für das genannte Benutzersignal enthält.

9. Anordnung nach Anspruch 5, die weiterhin eine weich unterdrückende Anordnung umfasst, die bei einem letzten Sprung auf dem genannten Abbildungspunkt in dem genannten Signal bei dessen Rekonstruktion arbeitet.

## Revendications

1. Dispositif de décodage pour décoder un flux de symboles de données représentant un signal d'utilisateur et organisé suivant un mécanisme d'entrelacement systématique parmi lesdits symboles, ledit dispositif comportant des moyens de désentrelacement pour désentrelacer ledit flux de symboles de données en conformité temporelle avec ledit signal d'utilisateur, ledit dispositif comportant un détecteur de contingence pour détecter une contingence de système et, à ce stade, fournir des pointeurs indiquant des symboles sélectifs comme étant suspects, ledit dispositif comprenant des moyens correctifs pour, sous le contrôle desdits pointeurs, exécuter une opération corrective en reconstruisant ledit signal d'utilisateur, caractérisé en ce que ladite contingence est une discontinuité de réception dans ledit flux de symboles de données avant ledit désentrelacement, ledit dispositif étant agencé pour fournir un point de cartographie de ladite discontinuité sur ledit signal d'utilisateur, ledit détecteur étant agencé pour fournir lesdits pointeurs par rapport aux symboles reçus avant ladite discontinuité et désentrelacés après ledit point de cartographie et également par rapport aux symboles reçus après ladite discontinuité et désentrelacés avant ledit point de cartographie.

2. Dispositif de décodage suivant la revendication 1, dans lequel ladite contingence est un saut de mémoire FIFO à l'intérieur dudit dispositif.

3. Dispositif de décodage suivant la revendication 1, dans lequel ladite contingence est un dépassement de capacité de mémoire FIFO avec une combinaison lecture-remise à zéro.

4. Dispositif de décodage suivant la revendication 1, 2 ou 3, dans lequel ladite opération corrective est basée sur des mots à plusieurs symboles après ledit désentrelacement, et les symboles ainsi pourvus de pointeurs sont des symboles minoritaires par rapport aux symboles qui sont reçus par rapport à ladite discontinuité dans une direction temporelle qui est en conformité avec celle de leur destination de désentrelacement par rapport audit point de cartographie.

5. Dispositif de décodage suivant la revendication 4, dans lequel ladite opération corrective est basée sur un code de correction des erreurs de symbole.

6. Dispositif de décodage suivant l'une quelconque des revendications 1 à 5, et comportant des moyens d'interface électromécaniques pour raccord à un support d'enregistrement inertiel.

7. Dispositif suivant la revendication 5, dans lequel ledit support d'enregistrement est un disque et ladite discontinuité est basée sur une accélération tangentielle dudit support d'enregistrement.

8. Dispositif suivant l'une quelconque des revendications 1 à 7, et exécuté sous la forme d'une unité complète en elle-même et portable comprenant des moyens de sortie pour ledit signal d'utilisateur.

9. Dispositif suivant la revendication 5, comprenant en outre un dispositif d'accord silencieux doux qui est opérationnel au niveau d'un saut final sur ledit point de cartographie dans ledit signal lors de la reconstitution de celui-ci.
